# EUROPÄISCHE PATENTSCHRIFT

(11) **EP 1 657 972 B1**
(45) Veröffentlichungstag und Bekanntmachung des Hinweises auf die Patenterteilung: **12.01.2011**
(21) Anmeldenummer: 05013717.3
(22) Anmeldetag: 24.06.2005
(51) Int. Cl.: C07F 9/48, C08K 5/00, C08K 5/5313, D01F 1/07

(54) **Phosphinat-Komplexverbindungen der 2., 3., 12. und 13. Gruppen und deren Verwendung als Flammenschutzmittel**
Phosphinate complexes of metals of the 2nd, 3rd, 12th and 13th groups and their use as flame proofing agents
Complexes phosphinates de métaux des groups 2, 3, 12 et 13 et leur utilisation comme agents d'ignifugation

(30) Priorität: 12.10.2004 DE 102004049614
(43) Veröffentlichungstag der Anmeldung: 17.05.2006
(73) Patentinhaber: Schill + Seilacher "Struktol" Aktiengesellschaft, 22113 Hamburg (DE)
(72) Erfinder: Just, Berthold Dr., 22397 Hamburg (DE); Dittrich, Uwe Dr., 01445 Radebeul (DE); Keller, Holger Dr., 71069 Sindelfingen - Darmsheim (DE); Döring, Manfred Prof. Dr., 76744 Wörth-Büchelberg (DE); Ahlmann, Martin Dr., 78467 Koblenz (DE); Storzer, Uwe Dr., 76135 Karlsruhe (DE)
(74) Vertreter: Prinz & Partner

(56) Entgegenhaltungen:
- DE-A1- 3 010 375
- FR-A- 1 545 460
- GB-A- 1 146 157
- US-A- 3 702 878
- PATENT ABSTRACTS OF JAPAN Bd. 2003, Nr. 12, 5. Dezember 2003 (2003-12-05) -& JP 2003 306585 A (SEKISUI CHEM CO LTD), 31. Oktober 2003 (2003-10-31)
- PATENT ABSTRACTS OF JAPAN Bd. 1996, Nr. 04, 30. April 1996 (1996-04-30) -& JP 07 330963 A (CHISSO CORP), 19. Dezember 1995 (1995-12-19)
- PATENT ABSTRACTS OF JAPAN Bd. 017, Nr. 030 (C-1018), 20. Januar 1993 (1993-01-20) -& JP 04 252245 A (CHISSO CORP), 8. September 1992 (1992-09-08)
- PATENT ABSTRACTS OF JAPAN Bd. 015, Nr. 508 (C-0897), 24. Dezember 1991 (1991-12-24) -& JP 03 223354 A (CHISSO CORP), 2. Oktober 1991 (1991-10-02)
- MORIZZI J ET AL: "Synthesis and characterization of some lamellar indium phosphonates" JOURNAL OF MATERIALS CHEMISTRY, Bd. 9, Nr. 4, 1999, Seiten 863-864, XP002373334 ISSN: 0959-9428
- PATENT ABSTRACTS OF JAPAN Bd. 2000, Nr. 22, 9. März 2001 (2001-03-09) & JP 2001 139586 A (SANKO CHEM CO LTD), 22. Mai 2001 (2001-05-22)
- MICHAELIS A ET AL: "Ueber aromatische Phosphorverbindungen" CHEMISCHE BERICHTE, Bd. 7, 1874, Seiten 1688-1693, XP009063369
- GEOFFROY M ET AL: "The electron spin resonance spectrum of X-irradiated phenylphosphinic acid and its salts" MOLECULAR PHYSICS, Bd. 24, Nr. 2, 1972, Seiten 335-340, XP009063349
- CHANG T C ET AL: "Thermogravimetric analysis study of a cyclic organo-phosphorus compound" PHOSPHORUS, SULFUR AND SILICON, Bd. 139, 1988, Seiten 45-55, XP009063330 ISSN: 1042-6507

## Beschreibung

Die Erfindung betrifft Phosphinat-Komplexverbindungen aus einem oder mehreren Kationen eines Metalls mit einer Koordinationszahl von mindestens 2 als Koordinationszentrum, an das jeweils eine der Koordinationszahl des Kations entsprechende Anzahl von Liganden koordinativ gebunden sind.

Die Erfindung betrifft außerdem Flammschutzmittel für Polymere, die eine Phosphinat-Komplexverbindung enthalten, sowie die Verwendung dieser Phosphinat-Komplexe als Flammschutzmittel, insbesondere für Polyester, Polyamide, Epoxidharze und daraus hergestellte Produkte, wie z.B. Fasern und Basismaterial für Leiterplatten.

Salze von Diorganylphosphinsäuren, insbesondere deren Alkali- und Erdalkalisalze, sowie deren Verwendung als Flammschutzmittel für Polyester und Polyamide sind beispielsweise aus DE-A-22 52 258 und 24 47 727 bekannt. Auch Gemische dieser Salze mit Stickstoffbasen sowie deren Verwendung als wirksame Flammschutzmittel sind beispielsweise aus EP-A-6568 und WO 97/39053 bekannt.

Auch aus dem US-Patent 4 208 321 sind Poly(metallphosphinate) der Metalle Cu, Fe, Sn, Co, W, Mn, Cr, V, Ti, Zn, Cd und Mo bekannt, die als Flammschutzmittel für Polyamide und Polyester verwendet werden. Auch hierbei handelt es sich um die Salze von Diorganylphosphinsäuren, zumal die Monoorganylphosphinsäuresalze wie zum Beispiel die Salze der Phenylphosphinsäure, die noch eine P-H-Bindung aufweisen, ausdrücklich als nachteilig bezeichnet werden, weil sie wegen ihrer leichten Oxidierbarkeit instabil sind und dadurch ihre Flammschutzwirkung mit der Zeit verlieren.

Aus der JP-A-2001-139586 ist die Verwendung der Zink- und Aluminiumsalze von (6H)-Dibenz(c,e)(1,2)-oxaphosphorin-6-on, das auch unter den Kürzeln "DOP" und "DOPO" bekannt ist, als Flammschutzmittel für organische Polymere bekannt.

Als Zwischenprodukte bei der Herstellung der Alkali- oder Erdalkalimetallsalze von DOP werden in der DE-A-30 10 375 2'-Hydroxydiphenyl-2-phosphinate, auch in Form von Gemischen mit Organohalogenverbindungen, beschrieben.

Die JP 2003-306 585 A beschreibt Verbundmaterialien aus einem Schichtsilikat und Polypropylen, wobei das Verbundmaterial einen Keimbildner umfasst. In der Druckschrift ist das Magnesiumsalz eines Hydroxybiphenylphosphinats beschrieben. Eine ähnliche Offenbarung findet sich in der JP 7-330 963 A.

Aus der JP 04-252 245 A sind Barium- oder Aluminiumsalze von 2'-Hydroxybiphenyl-2-phosphinat bekannt, die als Zusatz zu extrudierbaren Zusammensetzungen auf der Grundlage von kristallinen Polyolefinen mit anorganischen Füllstoffen verwendet werden. In der JP 03-223 354 A sind zu diesem Zweck die Zinksalze oder Bleisalze von 2'-Hydroxybiphenyl-2-phosphinat beschrieben.

DOP und dessen 6-Hydroxy-Derivat reagieren als additive Flammschutzmittel in Polymeren beim Zumischen in die Polymerschmelze sauer und führen deshalb bei Polyestern und Polyamiden zur Kettenspaltung. Die entsprechenden Alkali- und Erdalkalisalze reagieren basisch und führen ebenfalls durch Spaltung von Ester- und Amidbindungen zu einem Kettenabbau, was durch einen Viskositätsabfall bei den Polymeren erkennbar wird.

Die Verwendung von Monoorganyl-, insbesondere von Monoarylphosphinatsalzen, die eine P-H-Bindung enthalten, ist, wie schon erwähnt, deshalb nachteilig, weil sie infolge von Oxidationsprozessen und Migration ihre Flammschutzwirkung im Laufe der Zeit verlieren. Dies ist insbesondere bei flammfest ausgerüsteten Textilfaserprodukten und flammfest ausgerüsteten Leiterplatten aus Expoxidharzen ein Nachteil, da solche Produkte häufig über viele Jahre in Gebrauch sind, wobei die nachlassende oder sogar fehlende Flammschutzwirkung aber erst im Brandfalle bemerkt wird.

Die erwähnten, bekannten Diorganylphosphinate und deren Kombination mit Stickstoffbasen sind relativ teuer und aufwendig in der Herstellung, was die

Einsatzmöglichkeiten dieser Produkte als Flammschutzmittel für polymere Massenprodukte wie zum Beispiel Polyester- und Polyamidfasern und Leiterplatten auf Epoxidharzbasis, stark begrenzt.

Der Erfindung liegt deshalb die Aufgabe zugrunde, leicht und kostengünstig herstellbare, gleichzeitig aber hoch effiziente Phosphinatkomplexe als Flammschutzmittel für Polymere zu entwickeln, damit bei einer minimalen Menge eingesetzter Flammschutzmittel eine maximale Flammschutzwirkung erzielt wird, aber gleichzeitig die Materialeigenschaften und die Verarbeitungscharakteristiken der flammfest auszurüstenden Polymere erhalten bleiben und die Kosten für den Flammschutz dieser polymeren Massenprodukte möglichst gering gehalten werden können.

Diese Aufgabe wird erfindungsgemäß gelöst durch die Bereitstellung der Phosphinatkomplexe der Formel 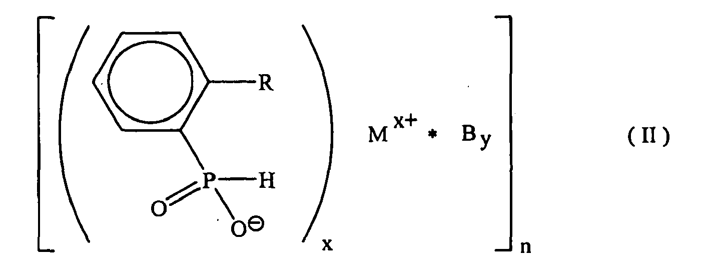 worin M eines der Metalle der zweiten, dritten, zwölften oder dreizehnten Gruppe des periodischen Systems der Elemente;
x die Zahl 2 oder 3;
R ein Wasserstoffatom oder ein 2-Hydroxyphenylrest;
B eine Lewis-Base;
y die Zahl 1 oder 2; und
n eine ganze Zahl von 1 bis 100
bedeuten.

Vorteilhafte Ausführungsformen der Phosphinatkomplexe der Formel II sind durch die Merkmale der Patentansprüche 2 bis 5 gekennzeichnet.

Die Struktur der erfindungsgemäßen Phosphinatkomplexe wird anhand der Zeichnung am Beispiel zweier Koordinationspolymere erläutert:
- Figur 1 zeigt die Struktur von Bis(2'-Hydroxybiphenyl-2-phosphinato)zink (nicht erfindungsgemäß),
- Figur 2 diejenige von Bis(Phenylphosphinato)-(N-methylimidazol)zink.

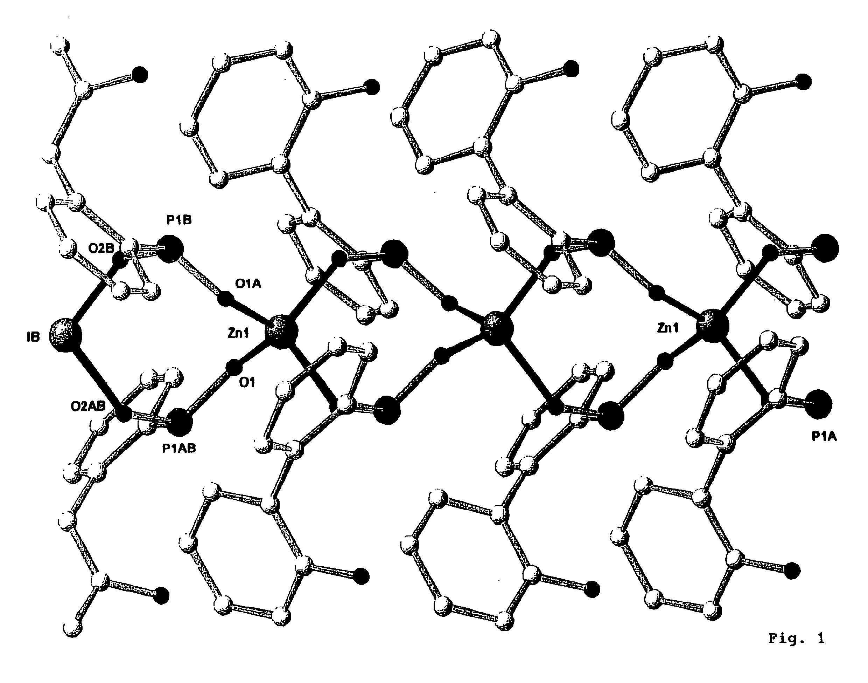

In dem Ausschnitt-aus dem Polymergerüst des polymeren Zinksalzes von 2'-Hydroxydiphenyl-2-phosphinat (Fig. 1) sieht man in der Mitte als Koordinationszentren vier Zn²⁺-Ionen mit der Koordinationszahl 4. Jedes Zinkkation ist koordinativ an die Sauerstoffatome von vier bidentalen Phosphinatliganden unter Bildung eines sogenannten Chelat-Komplexes (Ringschluß unter Beteiligung der als Koordinationszentren fungierenden Metallionen) gebunden.

Zwar ist die Koordinationszahl 4 bei Zn²⁺ energetisch besonders begünstigt und stabil, weil die von den vier Liganden zur Verfügung gestellten acht Elektronen das 4s- und die drei 4p-Orbitale vollständig auffüllen, aber das Zinkion kann auch die Koordinationszahl 6 aufweisen und weitere Liganden, beispielsweise aus der Gruppe der Lewis-Basen, koordinativ binden.

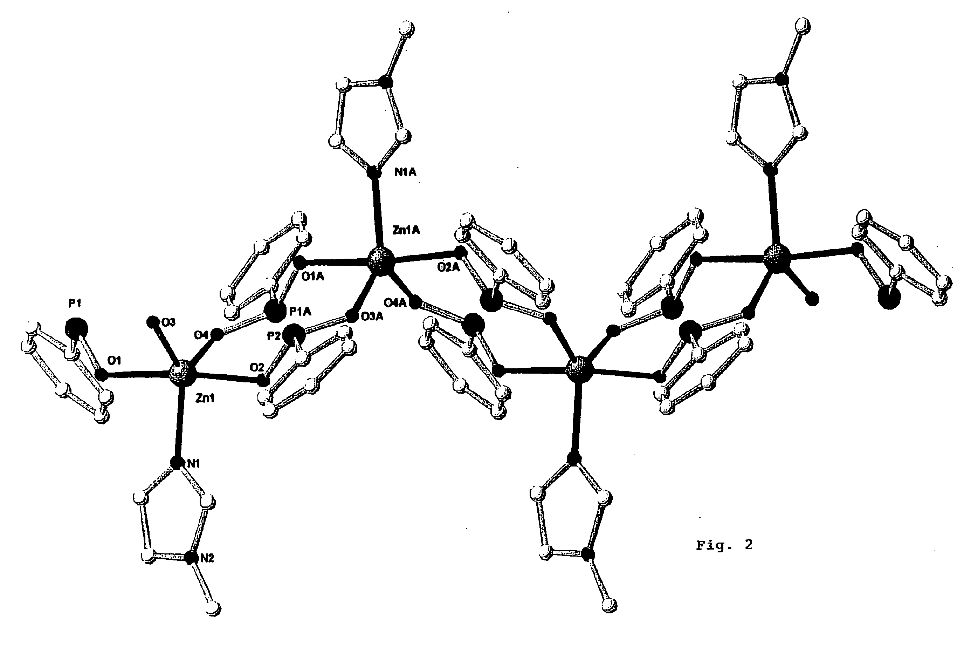

Zusätzlich oder anstelle der bidentalen Liganden, wie sie in Fig. 1 zu sehen sind, können auch an jedes Metallkation monodentale Liganden gebunden sein, beispielsweise Lewis-Basen. Im Bis(Phenylphosphinato)-(N-methylimidazol)zink (Fig.2) ist jedes Zinkkation koordinativ an die Sauerstoffatome von vier bidentalen Phenylphosphinatliganden und zusätzlich an das nicht-methylierte Stickstoffatom eines N-Methylimidazol-Liganden gebunden.

Da die Stickstoffbasen als Liganden die über Sauerstoffatome koordinierten Phosphinatliganden verdrängen können, kann es zu Kettenabbrüchen und damit zu geringeren Polymerisationsgraden bei den erfindungsgemäßen Verbindungen der allgemeinen Formel II kommen, bis hin zu den monomeren Phosphinatkomplexen der Formel II, bei denen n = 1 ist.

Gegenstand der Erfindung sind ferner Flammschutzmittel für Polymere, wobei die Flammschutzmittel einen Phosphinatkomplex der vorgenannten Formel II enthalten.

Die erfindungsgemäßen Flammschutzmittel können auch in Form einer physikalischen Mischung der Komplexe der Formel II mit einer Stickstoffbase vorliegen, wobei die Stickstoffbase ausgewählt ist aus der aus Melamin, Guanidin, Cyanursäure, Melamincyanurat, Melaminphosphat, Dimelaminphosphat, Melaminpyrophosphat, Melaminpolyphosphat, Dicyandiamid, Benzoguanin, Allantoin, Glykoluryl, Harnstoffcyanurat und deren Säureadditonssalzen bestehenden Gruppe. Bevorzugte Mischungen sind solche mit Melaminpolyphosphat oder Melamincyanurat als Stickstoffbase.

Die erfindungsgemäßen Phosphinatkomplexe können vorteilhaft als Flammschutzmittel für Polyester, Polyamide und Epoxidharze sowie für aus diesen Polymeren hergestellte Erzeugnisse wie z.B. Fasern und Leiterplattenbasismaterial verwendet werden.

Wie sich aus der nachfolgenden beispielhaften Beschreibung der Einarbeitung der erfindungsgemäßen Flammschutzmittel in Polymermassen (Polyamid-6) im Kneter ergibt, läßt sich mit Hilfe der erfindungsgemäßen Phosphinatkomplexe ein sehr guter Flammschutz unter Beibehaltung der Materialeigenschaften der Polymermassen auf einfache und kostengünstige Weise erreichen.

Die erfindungsgemäßen Phosphinatkomplexe lassen sich einfach und preisgünstig aus dem in industriellem Maßstab hergestellten und kommerziell verfügbaren DOP herstellen. Überraschenderweise hat sich gezeigt, daß die Zink-, Magnesium- und Aluminiumphosphinatkomplexe sowie deren Gemische mit Stickstoffbasen und Säureadditionssalzen von Stickstoffbasen eine hohe thermische Stabilität aufweisen und deshalb sehr geeignet sind, bei hohen Temperaturen in Polymere wie zum Beispiel Polyamid 6, Polyamid 6.6, Polyethylenterephthalat und Polybutylenterephthalat eingearbeitet zu werden, ohne das Polymer selbst und dessen Materialeigenschaften zu schädigen oder nachteilig zu verändern.

### Beispiel 1:

### Bis(2'-Hydroxybiphenyl-2-phosphinato)zink (nicht erfindungsgemäß)

Zu einer Lösung von 482,6 g 9,10-Dihydro-9-phospha-10-oxa-phenantren-9-oxid ("DOP"), dessen Herstellung beispielsweise aus EP 0 833 832 B1 bekannt ist, und 89,3 g Natriumhydroxid in Wasser wurde eine wäßrige Lösung von 152,13 g Zinkchlorid oder einer äquivalenten Menge eines anderen Zinksalzes hinzugefügt. Das Produkt fiel sofort aus. Nach Filtration wurde das Produkt mit Wasser gewaschen und getrocknet. Es wurden 558 g des polymeren Bis(2'-Hydroxybiphenyl-2-phosphinato)zink in Form eines farblosen Feststoffes erhalten. Die Ausbeute betrug 94%. Das erhaltene Koordinationspolymer besitzt die in Figur 1 wiedergegebene, durch Röntgenstrukturanalyse verifizierte Kristallstruktur. Die Röntgenstrukturanalyse ergab ein orthorhombisches Kristallsystem der Raumgruppe Pccn (Nr. 56). Für die Elementarzelle wurden folgende Abmessungen gemessen: a = 18.760 (4) Å, b = 20.250 (4) Å, c = 8.6285 (17) Å, α = β = γ = 90°. Die Bindungslängen zwischen dem Zinkkation und den vier koordinierten Sauerstoffatomen wurden mit 1.924, 1.925, 1.935 und 1.935 Å gemessen.

### Beispiele für die Herstellung von Phosphinatokomplexen der allgemeinen Formel II mit Lewis-Basen-Liganden.

### Beispiel 2:

### Bis(2'-Hydroxybiphenyl-2-phosphinato)-bis(N-methylimidazol)zink

23,17 g Bis(2'-Hydroxybiphenyl-2-phosphinato)zink, das gemäß Beispiel 1 hergestellt wurde, wurden in Methanol bei Raumtemperatur suspendiert. Nach der Zugabe von 47,5 g N-Methylimidazol wurde noch 18 Stunden lang gerührt. Nach dem Entfernen des Methanols unter vermindertem Druck wurde der Rückstand mit Diethylether gewaschen, wodurch 30,1 g (99% Ausbeute) Bis(2'-Hydroxybiphenyl-2-phosphinato)-bis(N-methylimidazol)zink in Form eines farblosen Pulvers erhalten wurden.

### Beispiel 3:

### Bis(2'-Hydroxybiphenyl-2-phosphinato)-bis(N-methylimidazol)kobalt

Die Herstellung erfolgte, wie in Beispiel 7 beschrieben, nur mit dem Unterschied, daß anstelle des Zinkkomplexes gemäß Beispiel 1 der Kobaltkomplex gemäß Beispiel 3 verwendet wurde.

### Beispiel 4:

### Bis(Phenylphosphinato)-(N-methylimidazol)zink

23,09 g Phenylphosphonigsäure wurden mit 6,5 g Natriumhydroxid in Wasser gerührt. Dann wurden 24,16 g Zinknitrat-Tetrahydrat zugegeben, worauf Bis(Phenylphosphinato)zink ausfiel. Letzteres wurde abfiltriert und mit einem Überschuß an N-Methylimidazol versetzt und 18 Stunden lang gerührt. Die entstandene ölige Phase wurde von der wäßrigen Phase abgetrennt und mit Tetrahydrofuran gewaschen. Das erhaltene Produkt wurde in einer Ausbeute von 62% in Form von 19,93 g eines Öls erhalten. Es handelte sich um Bis(Phenylphosphinato)-(N-methylimidazol)zink, dessen Röntgenstrukturanalyse die in Figur 2 wiedergegebene Struktur ergab. Die aus dem Öl gewonnenen Kristalle waren orthorhombisch mit der Raumgruppe Pna2(1) (Nr. 33). Die Elementarzelle hatte die Abmessungen a = 9.3546(9) Å, b = 9.7808 (9) Å, c = 19.9021 (19) Å mit α= β = γ = 90°. Die Bindungslängen zwischen Zink und den vier koordinativ gebundenen Sauerstoffatomen betrugen 1.950, 1.965, 2.152 und 2.166 Å; die Bindungslänge zwischen Zink und dem koordinierten Stickstoffatom des N-Methylimidazols wurde mit 2.038 Å gemessen.

### Beispiel 5:

### Bis(Phenylphosphinato)-(N-methylimidazol)kobalt

Die Herstellung erfolgte, wie in Beispiel 9 beschrieben, nur mit dem Unterschied, daß anstelle des Zinknitrat-Tetrahydrats eine äquivalente Menge eines wasserlöslichen Kobaltsalzes verwendet wurde.

### Beispiel für physikalische Mischungen aus Phosphinatkomplexen und Stickstoffbasen

### Beispiel 6 (nicht erfindungsgemäß) :

332,4 g Bis(2'-Hydroxybiphenyl-2-phosphinato)zink, hergestellt nach Beispiel 1, wurden mit 159,6 g Melamincyanurat vermischt. Die Mischung wurde als Flammschutzmittel verwendet.

### Prüfung der Phosphinatkomplexe als Flammschutzmittel für Polyamid-6

Um die flammhemmenden Eigenschaften der Phosphinatkomplexe und die Auswirkungen des Zusatzes der Produkte auf die Polymerisateigenschaften der flammhemmend zu modifizierenden Kunststoffe zu überprüfen, wurde ein handelsübliches Polyamid des Typs PA6-Bonamid BS 300 in einem HAAKE-Meßkneter vom Typ Rheocord 300p, Rheomix 610p mit zwei gegenläufigen Kneterwellen und elektrischer Heizung a) mit Bis(2'-hydroxybiphenyl-2-phosphinato)Zink gemäß Beispiel 1, b) mit der physikalischen Mischung dieses polymeren Zinksalzes mit Melamincyanurat gemäß Beispiel 6 und c) mit dem aus DE 19711523 C2 bekannten Addukt aus DOP und Itaconsäure als Vergleichsadditiv vermischt. Bei diesen Kneterversuchen betrug das Kammervolumen 60 cm³ und die Gesamtmenge an Reaktanten 55 g. Die Temperatur im Kneter wurde auf 260°C eingestellt.

Die Versuche wurden unter Standardbedingungen durchgeführt. Dabei wurde zunächst das Polymer eingefüllt und nach Aufschmelzen und Erreichen der Solltemperatur (nach ca. 2 bis 3 Minuten) erfolgte die Additivzugabe. Nun wurde noch weitere vier Minuten geknetet und die Probenahme durchgeführt. Während dieser Zeit wurden ständig Meßwerte für Drehmoment, Energie, Temperatur und Drehzahl als Funktion der Zeit registriert. Nach Beendigung der Verweilzeit und der Probenahme wurde die Reaktionsschmelze noch vor dem Erstarren aus der Kneterkammer manuell entfernt. Die Kneterprodukte wurden in bekannter Weise granuliert, und von den Granulaten wurden die relativen Lösungsviskositäten in 96%iger Schwefelsäure bestimmt.

Mit den Kneterprodukten wurde schließlich ein Brenntest durchgeführt, bei dem zunächst ein 2 bis 3 mm starker Strang oder "Draht" ausgezogen wurde, welcher 5 Sekunden lang in eine Flamme gehalten und dann aus der Flamme herausgenommen wurde. Das Brennverhalten wurde beurteilt und in die folgenden vier Kategorien klassifiziert:
- Probe brennt vollkommen ab
+ Probe brennt, erlischt nach Herausnehmen aus der Flamme und tropft ab, entzündet in den wenigsten Fällen eine Filterpapierunterlage
++ Probe brennt schwer, erlischt nach Herausnehmen aus der Flamme, entzündet Unterlage nicht
+++ Probe brennt nicht.

In der folgenden Tabelle 1 sind die analytischen Daten der Ausgangsmaterialien wiedergegeben

**Tabelle 1**

| Produkt | P-Gehalt [%] | Festpunkt [°C] | Beginn Zersetzung [°C] |
|---|---|---|---|
| PA6-BS300 | - | 224 | 370 |
| Beispiel 1 | 10,60 | 209 | 210 |
| Beispiel 6 | 8,14 | 390 | 209/320 |
| DOP-ITS (Vergleich) | 8,90 | 194,9 | 200 |

In Tabelle 2 sind die analytischen Daten der Kneterprodukte und das Ergebnis des Brenntests dargestellt.

**Tabelle 2**

| Produkt | Masseanteil [%] | Lösungs-viskosität [mPas] | P-Gehalt [%] | Brenntest |
|---|---|---|---|---|
| PA6-BS300 | 100 | 2,71 | - | - |
| Beispiel 1 | 12,5 | 2,39 | n.b. | ++ |
| Beispiel 6 | 12,5 | 2,41 | n.b. | ++ |
| DOP-ITS (Vergleich) | 4,5 | 1,97 | 0,43 | - |

| | | | | |
|---|---|---|---|---|
| n.b. = nicht bestimmt | | | | |

Wie der Vergleich der gemessenen Lösungsviskositäten zeigt, verursacht die Zugabe des bekannten Flammschutzmittels DOP-ITS einen weit stärkeren Polymerabbau als die Flammschutzmittel gemäß den Beispielen 1 und 6, was sich an dem dramatischen Abfall der Lösungsviskosität von 2,71 auf 1,97 zeigt, während die Flammschutzmittel zu einem wesentlich geringeren Abfall der Lösungsviskositäten von 2,71 auf 2,39 bzw. 2,41 führen. Wenn man die unterschiedlichen Masseanteile der getesteten Flammschutzmittel mitberücksichtigt, ist der Unterschied noch weit dramatischer: Denn der Abfall der Lösungsviskosität auf 1,97 tritt bei dem bekannten Flammschutzadditiv DOP-ITS schon bei einem Masseanteil von nur 4,5% ein. Eine Erhöhung auf 12,5% war in diesem Falle nicht möglich, weil die Polymereigenschaften bei größeren Masseanteilen vollkommen zusammenbrachen. Da es für die flammhemmende Wirkung aber im wesentlichen auf den Phosphorgehalt ankommt, ist natürlich ein höherer Masseanteil als 4,5% grundsätzlich wünschenswert.

Wie die Kneterversuche gezeigt haben, sind die erfindungsgemäßen Koordinationspolymere und die daraus herstellbaren physikalischen Mischungen mit Stickstoffbasen als Flammschutzmittel für Polyamid und andere Polymere geeignet. Da die Polymereigenschaften in weit höherem Maße erhalten bleiben als bei Zusatz bekannter Flammschutzmittel, sind die erfindungsgemäßen Produkte auch für Extruderumsetzungen geeignet, so daß aus den Granulaten Spritzgußprüfkörper zur Bestimmung der flammhemmenden Wirkung nach UL 94 hergestellt werden können. Bei der Verwendung zur flammhemmenden Ausrüstung von Filamenten und Fasern werden die erfindungsgemäßen Koordinationspolymere in entsprechende Masterbatch-Granulate eingearbeitet, welche dann im Extruder dem Hauptgranulatstrom kontinuierlich zugeführt werden.

## Patentansprüche

1. Phosphinatkomplex der Formel II, 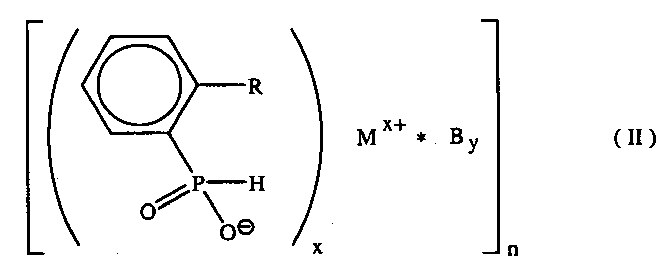 worin M eines der Metalle der zweiten, dritten, zwölften oder dreizehnten Gruppe des periodischen Systems der Elemente;
x die Zahl 2 oder 3;
R ein Wasserstoffatom oder ein 2-Hydroxyphenylrest;
B eine Lewis-Base;
y die Zahl 1 oder 2; und
n eine ganze Zahl von 1 bis 100
bedeuten.

2. Phosphinatkomplex nach Anspruch 1, **dadurch gekennzeichnet, dass** in der Formel 11 x = 2 und das Metall (M) Zn, Mg, Ca oder Co ist.

3. Phosphinatkomplex nach Anspruch 1, **dadurch gekennzeichnet, dass** in der Formel II x = 3 und das Metall (M) Al oder Y ist.

4. Phosphinatkomplex nach einem der Ansprüche 1 bis 3, **dadurch gekennzeichnet, dass** die Lewis-Base (B) ausgewählt ist aus der aus Wasser, Alkoholen, Aminen und cyclischen Stickstoffbasen bestehenden Gruppe.

5. Phosphinatkomplex nach Anspruch 4, **dadurch gekennzeichnet, dass** die Lewis-Base (B) ausgewählt ist aus der aus N-Methylimidazol, Melamin, Guanidin Cyanursäure, Dicyandiamid und deren Derivaten bestehenden Gruppe.

6. Flammschutzmittel für Polymere, enthaltend einen Phosphinatkomplex gemäß einem der Ansprüche 1 bis 5.

7. Verwendung eines Phosphinatkomplexes gemäß einem der Ansprüche 1 bis 5 als Flammschutzmittel für Polyester, Polyamide und Epoxidharze sowie daraus hergestellte Erzeugnisse.

8. Verwendung eines Phophinatkomplexes nach Anspruch 7 als Flammschutzmittel für Fasern aus Polyester oder Polyamid und für Leiterplatten aus Epoxidharz.

## Claims

1. A phosphinate complex of the formula II, 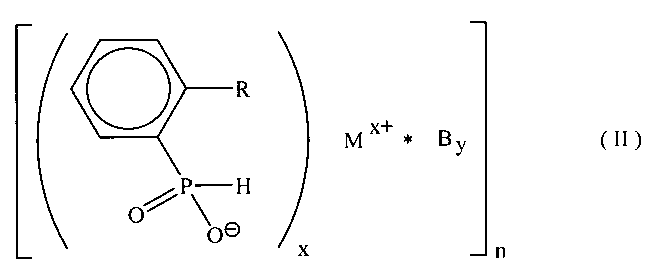 where M denotes one of the metals of the second, third, twelfth or thirteenth groups of the periodic table of the elements;
x denotes the number 2 or 3;
R denotes a hydrogen atom or a 2-hydroxyphenyl residue;
B denotes a Lewis base;
y denotes the number 1 or 2; and
n denotes an integer from 1 to 100.

2. The phosphinate complex according to claim 1, **characterized in that** in the formula II, x = 2 and the metal (M) is Zn, Mg, Ca or Co.

3. The phosphinate complex according to claim 1, **characterized in that** in the formula II, x = 3 and the metal (M) is Al or Y.

4. The phosphinate complex according to any of claims 1 to 3, **characterized in that** the Lewis base (B) is selected from the group consisting of water, alcohols, amines and cyclic nitrogenous bases.

5. The phosphinate complex according to claim 4, **characterized in that** the Lewis base (B) is selected from the group consisting of N-methylimidazole, melamine, guanidine, cyanuric acid, dicyandiamide and their derivatives.

6. A flame retardant for polymers, containing a phosphinate complex according to any of claims 1 to 5.

7. Use of a phosphinate complex according to any of claims 1 to 5 as a flame retardant for polyesters, polyamides and epoxy resins and products manufactured therefrom.

8. Use of a phosphinate complex according to claim 7 as a flame retardant for fibers made from polyester or polyamide and for printed circuit boards made from epoxy resin.

## Revendications

1. Complexe phosphinate de la formule II, 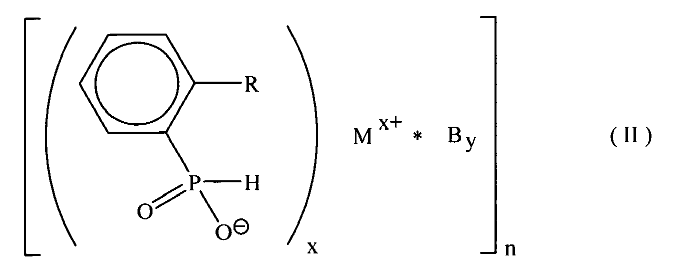 dans laquelle
M est un des métaux du deuxième, troisième, douzième ou treizième groupe du système périodique des éléments ;
x est le nombre 2 ou 3;
R est un atome d'hydrogène ou un radical 2-hydroxyphényle B est une base de Lewis;
y est le nombre 1 ou 2; et
n est un nombre entier de 1 à 100.

2. Complexe phosphinate selon la revendication 1, **caractérisé en ce que** dans la formule II, x = 2 et le métal (M) est Zn, Mg, Ca ou Co.

3. Complexe phosphinate selon la revendication 1, **caractérisé en ce que** dans la formule II, x = 3 et le métal (M) est Al ou Y.

4. Complexe phosphinate selon l'une des revendications 1 à 3, **caractérisé en ce que** la base de Lewis (B) est choisie parmi le groupe constitué par de l'eau, des alcools, des amines et des bases d'azote cycliques.

5. Complexe phosphinate selon la revendication 4, **caractérisé en ce que** la base de Lewis (B) est choisie parmi le groupe constitué par le N-méthylimidazole, la mélamine, la guanidine, l'acide cyanurique, la dicyanamide et leurs dérivés.

6. Agent d'ignifugation pour polymères, contenant un complexe phosphinate selon l'une quelconque des revendications 1 à 5.

7. Utilisation d'un complexe phosphinate selon l'une des revendications 1 à 5 en tant qu'agent d'ignifugation pour polyesters, polyamides et résines époxy ainsi que pour des produits fabriqués dans ces matières.

8. Utilisation d'un complexe phosphinate selon la revendication 7 en tant qu'agent d'ignifugation pour des fibres en polyester ou polyamide et pour des cartes de circuits imprimés en résine époxy.
